# EUROPEAN PATENT SPECIFICATION

(11) **EP 1 726 093 B1**
(45) Date of publication and mention of the grant of the patent: **10.07.2013**
(21) Application number: 05708723.1
(22) Date of filing: 11.03.2005
(51) Int. Cl.: H03H 7/42, H03H 9/58, H03H 9/70

(54) **COUPLED BAW RESONATOR BASED DUPLEXERS**
DUPLEXER AUF DER BASIS EINES GEKOPPELTEN BAW-RESONATORS
RESONATEUR DE DISPOSITIF D'ONDE ACOUSTIQUE EN VOLUME COUPLE A BASE DE DUPLEXEURS

(30) Priority: 19.03.2004 US 804830
(43) Date of publication of application: 29.11.2006
(73) Proprietor: Nokia Corporation, 02150 Espoo (FI); Avago Technologies Wireless IP (Singapore) Pte. Ltd., Singapore 768923 (SG)
(72) Inventor: ELLÄ, Juha, FI-24800 Halikko (FI); AIGNER, Robert, 82008 Unterhaching (DE)
(74) Representative: Anderson, Oliver Ben
(86) International application number: PCT/IB2005/000629
(87) International publication number: WO 2005/091501

(56) References cited:
- EP-A2- 1 292 026
- DE-A1- 10 319 554
- US-B1- 6 720 844
- US-B2- 6 670 866
- LAKIN K.M.: 'Coupled Resonator Filters' 2002 IEEE ULTRASONICS SYMPOSIUM vol. 1, 08 October 2002 - 11 October 2002, pages 901 - 908, XP002990986

## Description

The present invention relates generally to bulk acoustic wave resonators and filters and, more particularly, to bulk acoustic wave baluns used in filters and duplexers.

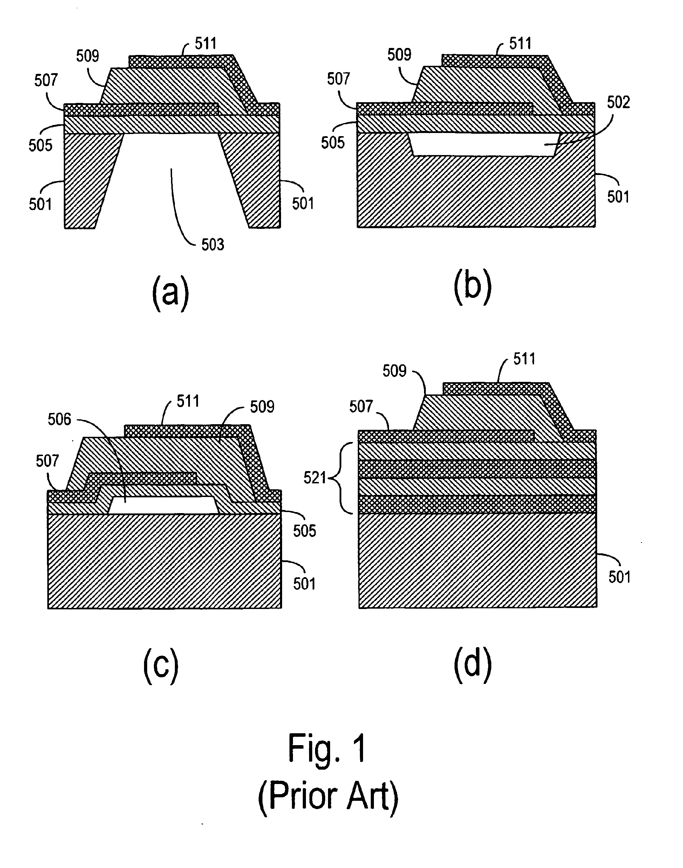

It is known that a bulk acoustic-wave (BAW) device is, in general, comprised of a piezoelectric layer sandwiched between two electronically conductive layers that serve as electrodes. When a radio frequency (RF) signal is applied across the device, it produces a mechanical wave in the piezoelectric layer. The fundamental resonance occurs when the wavelength of the mechanical wave is about twice the thickness of the piezoelectric layer. Although the resonant frequency of a BAW device also depends on other factors, the thickness of the piezoelectric layer is the predominant factor in determining the resonant frequency. As the thickness of the piezoelectric layer is reduced, the resonance frequency is increased. BAW devices have traditionally been fabricated on sheets of quartz crystals. In general, it is difficult to achieve a device of high resonance frequency using this fabrication method. When fabricating BAW devices by depositing thin-film layers on passive substrate materials, one can extend the resonance frequency to the 0.5 -10 GHz range. These types of BAW devices are commonly referred to as thin-film bulk acoustic resonators or FBARs. There are primarily two types of FBARs, namely, BAW resonators and stacked crystal filters (SCFs). An SCF usually has two or more piezoelectric layers and three or more electrodes, with some electrodes being grounded. The difference between these two types of devices lies mainly in their structure. FBARs are usually used in combination to produce passband or stopband filters. The combination of one series FBAR and one parallel, or shunt, FBAR makes up one section of the so-called ladder filter. The description of ladder filters can be found, for example, in Ella (U.S. Patent No. 6,081,171, hereafter referred to as *Ella'171*). As disclosed in *Ella'171,* an FBAR-based device may have one or more protective layers commonly referred to as the passivation layers. A typical FBAR-based device is shown in Figures 1a to 1d. As shown in Figures 1a to 1d, the FBAR device comprises a substrate **501,** a bottom electrode **507,** a piezoelectric layer **509,** and a top electrode **511.** The electrodes and the piezoelectric layer form an acoustic resonator. The FBAR device may additionally include a membrane layer **505.** As shown in Figure 1a, an etched hole **503** is made on the substrate **501** to provide an air interface, separating the resonator from the substrate **501.** Alternatively, an etched pit **502** is provided on the substrate **501,** as shown in Figure 1b. It is also possible to provide a sacrificial layer **506** separating the resonator and the substrate, as shown in Figure 1c. It is also possible to form an acoustic mirror **521** between the bottom electrode **507** and the substrate **501** for reflecting the acoustic wave back to the resonator, as shown in Figure 1d. The substrate can be made from silicon (Si), silicon dioxide (SiO2), Gallium Arsenide (GaAs), glass or ceramic materials. The bottom electrode and top electrode can be made from gold (Au), molybdenum (Mo), tungsten (W), copper (Cu), nickel (Ni), titanium (Ti), Niobium (Nb), silver (Ag), tantalum (Ta), cobalt (Co), aluminum (Al) or a combination of these metals, such as tungsten and aluminum. The piezoelectric layer **130** can be made from zinc oxide (ZnO), zinc sulfide (ZnS), aluminum nitride (AlN), lithium tantalate (LiTaO3) or other members of the so-called lead lanthanum zirconate titanate family. Additionally, a passivation layer typically made from a dielectric material, such as SiO2, Si3N4, or polyimide, is used to serve as an electrical insulator and to protect the piezoelectric layer. It should be noted that the sacrificial layer **506** in a bridge-type BAW device, as shown in Figure 1c, is, in general, etched away in the final fabrication stages to create an air interface beneath the device. In a mirror-type BAW device, as shown in Figure 1d, the acoustic mirror **521** consists of several layer pairs of high and low acoustic impedance materials, usually a quarter-wave thick. The bridge-type and the mirror-type BAW devices are known in the art.

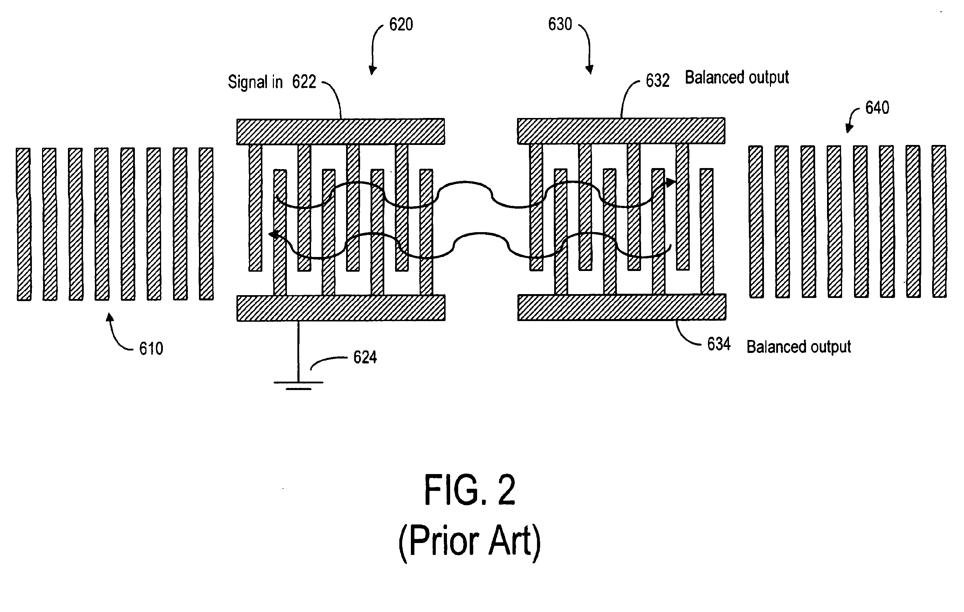

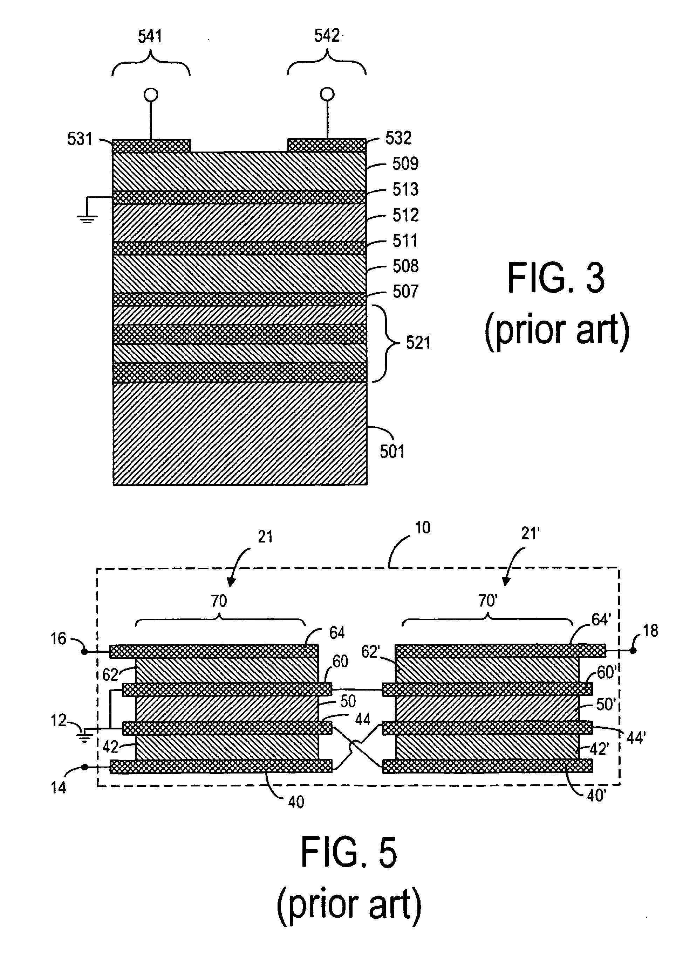

It is also known in the art that FBARs can be used to form impedance element filters in a ladder filter configuration that has unbalanced input and output ports, or in a lattice filter configuration that has balanced ports. In some applications it would be advantageous to transform an unbalanced input to a balanced output (or vice versa) within a filter. Such filters have been produced using acoustically coupled surface acoustic wave (SAW) resonators. Basically these structures are based on a pair of resonators, as shown in Figure 2. As shown, the first resonator **620** generates the acoustic wave and the second resonator **630** acts as a receiver. Since the resonators are not electrically connected, one of them can be connected as an unbalanced device and the other can be used in either as a balanced or an unbalanced device. As shown in Figure 2, the first resonator **620** provides an unbalanced port **622** for signal input, whereas the second resonator **630** provides two ports **632, 634** for balanced signal outputs. As shown, numerals **610** and **640** denote reflectors or acoustic mirrors for the surface acoustic wave device. This same principle can be used in a BAW device having a structure that has two piezoelectric layers, one on top of each other. Using such a structure, it is possible to perform this unbalanced-to-balanced transformation. This structure can then be used as part of a filter or even a duplexer. One possible way of realizing such a structure is described in "High Performance Stacked Crystal Filters for GPS and Wide Bandwidth Applications", K.M. Lakin, J. Belsick, J.F. McDonald, K.T. McCarron, IEEE 2001 Ultrasonics Symposium Paper 3E-6, October 9, 2001 (hereafter referred to as *Lakin*). Figure 3 is a coupled resonator filter (CRF) disclosed in *Lakin.* As shown in Figure 3, the CRF is formed by a bottom electrode **507,** a bottom piezoelectric layer **508,** a cross-over electrode **511,** a plurality of coupling layers **512,** a ground electrode **513,** a top piezoelectric layer **509** and two separate top electrodes **531** and **532.** As such, the CRF has a first vertical pair **541** of resonators and a second vertical pair **542** of resonators. Each of the vertical pairs acts as a one-pole filter. In series, the two vertical pairs act as a two-pole filter. The CRF is made on a substrate **501** separated by an acoustic mirror **521.**

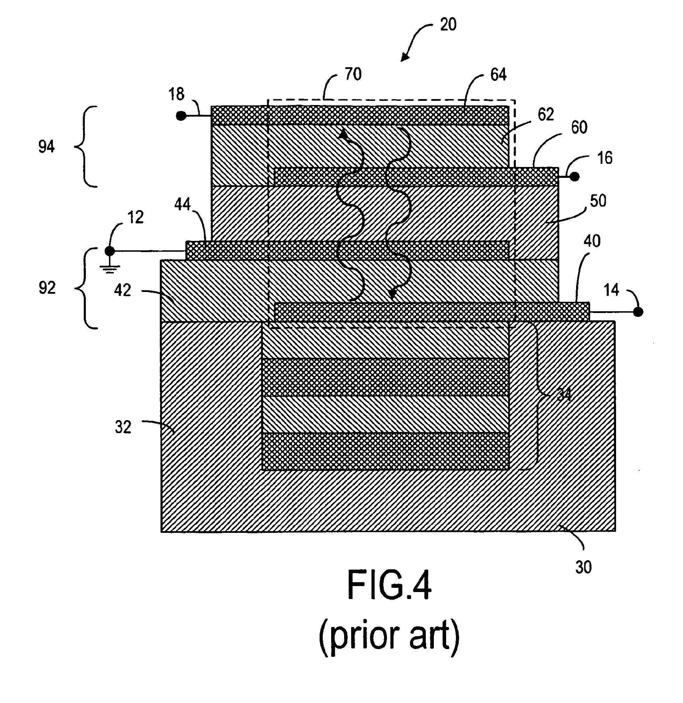

Ella et al. (U.S. Patent No. 6,670,866 B2, hereafter referred to as *Ella'866*) discloses a BAW device with two resonators and a dielectric layer therebetween. As shown in Figure 4, the BAW device **20** is formed on a substrate **30** and comprises a first electrode **40,** a first piezoelectric layer **42,** a second electrode **44** connected to the device ground **12,** a third electrode **60,** a dielectric layer **50** between the second electrode **44** and the third electrode **60,** a second piezoelectric layer **62** and a fourth electrode **64.** The first electrode **40,** the first piezoelectric layer **42** and the second electrode **44** have an overlapping area for forming a first resonator **92.** The third electrode **60,** the second piezoelectric layer **62** and the fourth electrode **64** have an overlapping area for forming a second resonator **94.** The bulk acoustic wave device **20** has a resonant frequency and an acoustic wavelength, λ, characteristic of the resonant frequency. The thickness of the first and second piezoelectric layers **42, 62** is substantially equal to λ/2. Furthermore, the device **20** has an acoustic mirror **34** formed between the first electrode **40** and the substrate **30** to reflect acoustic waves back to the first resonator **92.** As shown in Figure 4, a section of the first electrode **40** is exposed for use as a connection point to the signal input end **14** of a balun **10** (see Figure 5). Similarly, a section of the second electrode **44** is exposed for use as a connection point to the device ground **12.** The first resonator **92** and the second resonator **94** have an overlapping area **70,** defining an active area of the bulk acoustic wave device **20.** The device **20** has a first signal output end **16** and a second signal output end **18.**

*Ella'886* also discloses a balun for use in applications with lower bandwidth requirements. As shown in Figure 5, the balun **10** has two identical stacks **21, 21'** of layers, similar to the bulk acoustic wave device **20** of Figure 4. However, the first electrode **40'** and the third electrode **60'** of the layer stack **21',** and the second electrode **44** and the third electrode **60** of the layer stack **20** are connected to ground **12.** In addition, the second electrode **44'** of the layer stack **21'** is connected to the first electrode **40** of the layer stack **21** and is used as the signal input end **14.** The top electrode **64** of the layer stack **21** is used as the first signal output end **16,** while the top electrode **64'** of the layer stack **21'** is used as the second signal output end **18.** With the double-structure, there is no need for the compensation capacitance because the electrodes **60, 60'** below the upper piezoelectric layers **62, 62'** are grounded. This electric shielding effect results in the symmetric impedance for the first and second signal output ends **16, 18.** The parasitic capacitance of the dielectric layers **50, 50'** is parallel to the signal input end **14.** This parasitic capacitance somewhat degrades the bandwidth of the device but does not harm its symmetry. The cross-connected input electrodes **40, 44'** generate a perfect 180° phase between the acoustic waves in the stack **21** and the stack **21'.**

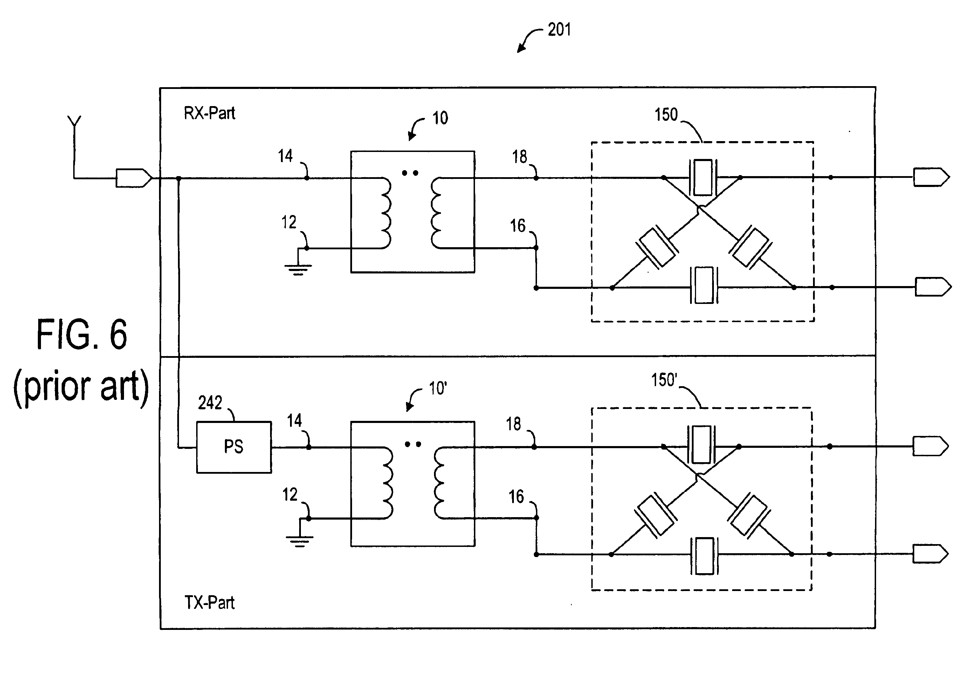

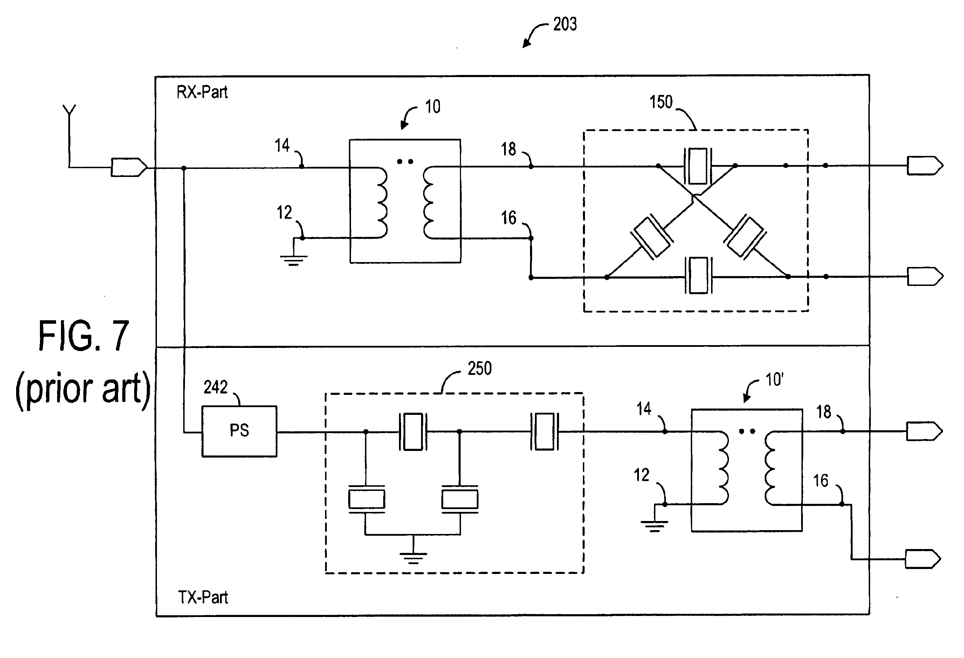

*Ella'886* also discloses that the balun **10** can be used as part of a filter that has one unbalanced port and two balanced ports. Two baluns **10** can be coupled to lattice filters **150** to form a duplexer **201** as shown in Figure 6. In Figure 6, a phase shifter **242** is used for filter matching. Similarly, two baluns **10** can be coupled to one lattice filter **150** and one ladder filter **250** to form a duplexer **203,** as shown in Figure 7.

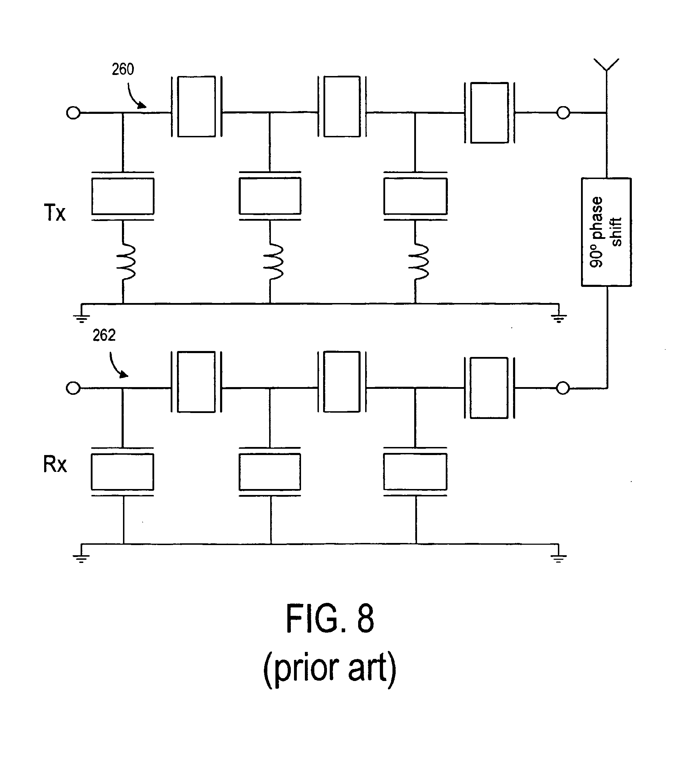

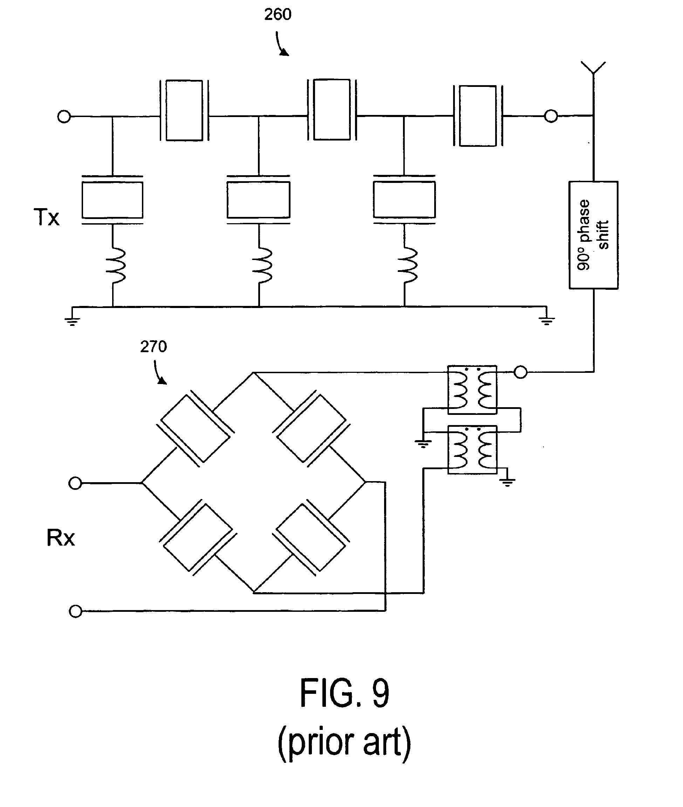

It is also possible to form a simple duplexer by using two single-ended ladder filters and a phase shifter, as shown in Figure 8. As shown in the figure, a single-ended ladder filter **260** is used for Tx and another single-ended ladder filter **262** is used for Rx. However, it usually requires that some inductance components, such as coils, to be connected in series with some of the shunt resonators in the Tx filter order to shift the natural notch to coincide with the Rx frequency. These coils not only cause additional losses in the duplexer, but also create other higher resonance frequencies, further degrading the overall out-of-band attenuation of a single-ended filter. In order to reduce the out-of-band attenuation in the Rx path, it is possible to combine a fully balanced Rx filter with a single-ended Tx filter, as shown in Figure 9. As shown in Figure 9, the fully balanced Rx filters **270** are connected to a pair of connected (in series) baluns. The problem with this approach is that any loss associated with the baluns at the antenna port will also cause losses in the Tx path. The Tx path also suffers from the degraded out-of-band due to the inductance.

It is thus advantageous and desirable to provide a simple duplexer that does not have the above-mentioned disadvantageous.

According to a first aspect of the invention, there is provided a duplexer for use in a communication device, the communication device having
an antenna for conveying communication signals;
a transmit path operatively connected to the antenna for transmitting the signals; and
a receive path operatively connected to the antenna for receiving the signals, the duplexer comprising:
a first coupled resonator device disposed in the transmit path for filtering the signals in the transmit path;
a second coupled resonator device disposed in the receive path for filtering the signals in the receive path; and
a phase shifter disposed in the receive path and operatively connected to the second coupled resonator device, wherein each of the first and second coupled resonator devices comprises:
   an input end for receiving the signals in the corresponding path, and an output end for providing filtered signals in the corresponding path;
   a first resonator operatively connected to the input end to provide acoustic wave signals indicative of the received signals;
   a first delay section, responsive to the acoustic wave signals, for providing delayed acoustic wave signals;
   an intermediate resonator having a first end and a second end, responsive to the delayed acoustic wave signals at the first end, for producing at the first and second ends electric signals indicative of the delayed acoustic wave signals for generating further acoustic wave signals at the second end;
   a second delay section, responsive to the further acoustic wave signals, for providing further delayed acoustic wave signals; and
   a second resonator operatively connected to the output end, for providing the filtered signals to the output end responsive to the further delayed acoustic wave signals,
   wherein the first delay section and the second delay section are separately disposed on the intermediate resonator.

The phase shifter may be disposed between the second coupled resonator device and the antenna. The duplexer may further comprise a further phase shifter disposed in the transmit path and operatively connected to the first coupled resonator device. The further phase shifter may be disposed between the first coupled resonator device and the antenna. The first coupled resonator device may be disposed between the further phase shifter and the antenna.

The input end of the first coupled resonator device may comprise two input terminals, and the output end of the first coupled resonator device may comprise two output terminals, wherein one of the two input terminals and one of the two output terminals are operatively connected to ground.

The input end of the second coupled resonator device may comprise two input terminals, wherein one of the two input terminals is operatively connected to ground to achieve a single-to-balanced transformation. The input end of the first coupled resonator device may comprise two input terminals, and the output end of the first coupled resonator device may comprise two output terminals, wherein one of the two input terminals and one of the two output terminals are operatively connected to ground.

The first and second resonators may be bulk acoustic wave devices.

Each of the phase shifter and the further phase shifter may comprise a transmission line. Each of the phase shifter and the further phase shifter may comprise one or more lump elements.

The further phase shifter may comprise one or more lump elements integrated with the first coupled resonator device.

There may be provided a communication device comprising:
an antenna port for conveying communication signals;
a transceiver having a transmit port and a receive port; and
the duplexer.

The duplexer may further comprise a further phase shifter disposed in the transmit path and operatively connected to the first coupled resonator device.

The communication device may comprise a mobile terminal.

Each of the first and second delay sections in the first and second coupled devices may comprise a structure composed of silicon dioxide and tungsten layers.

The first coupled resonator device may have a single-to-single configuration and the second coupled resonator device may have a single-to-balanced transformation.

According to a second aspect of the invention, there is provided a coupled resonator device, comprising:
an input end for receiving the signals in the corresponding path, and an output end for providing filtered signals in the corresponding path;
a first resonator, operatively connected to the input end to provide acoustic wave signals indicative of the received signals;
a first delay section, responsive to the acoustic wave signals, for providing delayed acoustic wave signals;
an intermediate resonator having a first end and a second end, responsive to the delayed acoustic wave signals at the first end, for producing electric signals at the first and second ends indicative of the delayed acoustic wave signals for generating further acoustic wave signals at the second end;
a second delay section, responsive to the further acoustic wave signals, for providing further delayed acoustic wave signals; and
a second resonator, operatively connected to the output end, for providing the filtered signals to the output end responsive to the further delayed acoustic wave signals,
wherein the first delay section and the second delay section are separately disposed on the intermediate resonator.

The resonator device may further comprise a substrate, the intermediate resonator may comprise:
a first electrode disposed on the substrate;
a piezoelectric layer disposed on the first electrode; and
a second electrode disposed on the piezoelectric layer, the second electrode having a first end and a second end,
   and
the first delay section may be disposed on the first end of the second electrode;
the second delay section may be disposed on the second end of the second electrode;
the first resonator may be disposed on the first delay section; and
the second resonator may be disposed on the second delay section.

Each of the first and second resonators may comprise a pair of electrodes and a further piezoelectric layer disposed between the pair of electrodes.

The resonator device may further comprise an acoustic mirror disposed adjacent to the intermediate resonator, between the first electrode and the substrate.

Each of the first and second delay sections may comprise a plurality of dielectric materials.

Each of the first and second delay sections may comprise a structure composed of silicon dioxide and tungsten layers.

The input end may comprise two input terminals, wherein one of the two input terminals is operatively connected to a non-acoustic phase shifting component. The other of the two input terminals may be operatively connected to ground.

The first resonator may have a first resonant frequency and the second resonator may have a second resonant frequency slightly different from the first resonant frequency.

The present invention will become apparent upon reading the description taken in conjunction with Figures 10-13.
Figure 1a is a cross-sectional view illustrating a typical bulk acoustic wave device having a resonator and a membrane formed on a substrate, wherein the substrate has a through hole for providing an air interface for the membrane.
Figure 1b is a cross-sectional view illustrating a typical bulk acoustic wave device having a resonator and a membrane formed on a substrate, wherein the substrate has an etched section for providing an air interface for the membrane.
Figure 1c is a cross-sectional view illustrating a typical bulk acoustic wave device having a resonator and a membrane formed on a substrate, wherein a sacrificial layer is formed between the membrane and the substrate.
Figure 1d is a cross-sectional view illustrating a typical bulk acoustic wave device having a resonator formed on a substrate, wherein an acoustic mirror is formed between the substrate and the bottom electrode of the resonator.
Figure 2 is a schematic representation showing a prior art arrangement, wherein two resonators are used to transform unbalanced signals to balanced signals.
Figure 3 is a cross sectional view illustrating a prior art arrangement of a coupled resonator filter, wherein two crystal filter resonators are horizontally spaced.
Figure 4 is a schematic representation showing a prior art balun with one signal input port and two signal output ports.
Figure 5 is a schematic representation showing a prior art balun with two filter stacks.
Figure 6 is a block diagram showing a prior art duplexer wherein each of the transceiver filters has a balun and a lattice filter segment.
Figure 7 is a block diagram showing a prior art duplexer, wherein one transceiver filter has a balun coupled to a lattice filter segment, and the other transceiver filter has a balun coupled to a ladder filter.
Figure 8 is a block diagram showing a prior art duplexer with two single-ended filters.
Figure 9 is a block diagram showing a prior-art duplexer with a single-ended filter and a fully balanced filter.
Figure 10 is a schematic representation showing the coupled BAW resonator, according to the present invention.
Figure 11 is a block diagram illustrating the acoustic and electrical coupling in the coupled BAW resonator.
Figure 12a is a block diagram showing a duplexer, according to an embodiment of the present invention.
Figure 12b is a block diagram showing the duplexer, according to another embodiment of the present invention.
Figure 12c is a block diagram showing the duplexer, according to yet another embodiment of the present invention.
Figure 13 is a schematic representation showing a communications device having a duplexer, according to the present invention.

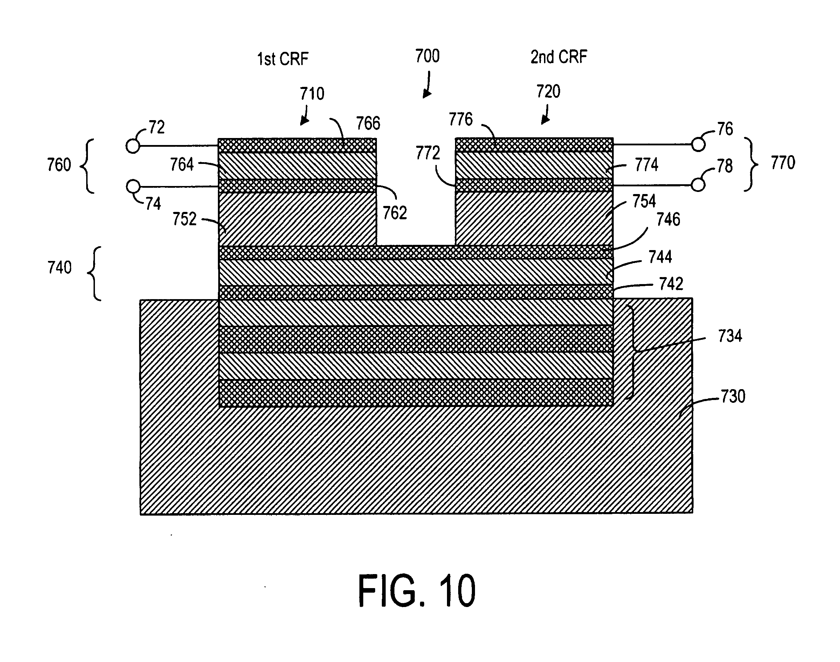

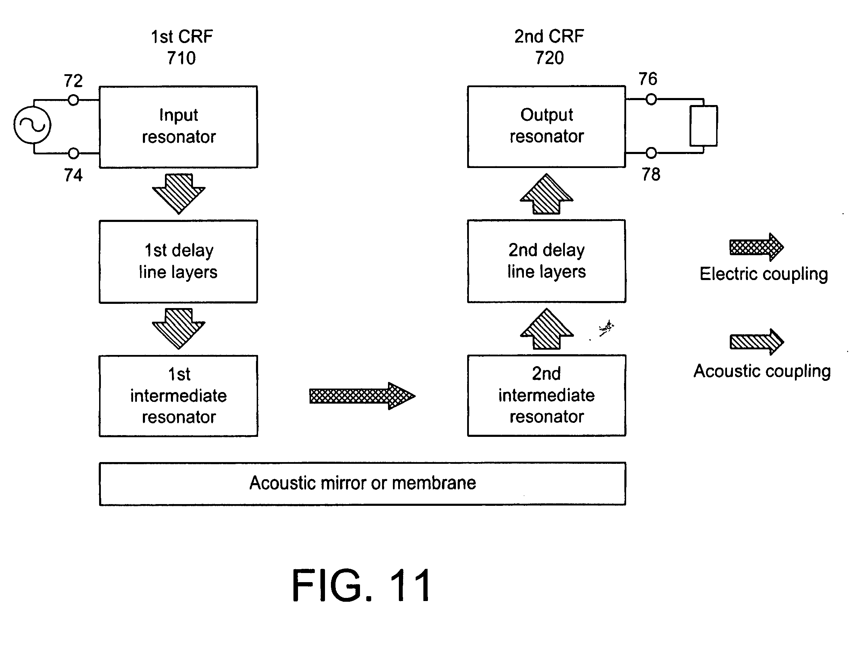

The duplexer, according to the present invention, is based on coupled BAW resonator devices. The coupled resonator device is shown in Figure 10. The coupled resonator device **700** comprises a coupled resonator filter (CRF) **710** coupled to another CRF **720.** As shown in Figure 10, the resonator device **700** comprises a substrate **730,** a lower resonator **740,** a first delay **752,** a second delay **754,** a first upper resonator **760** and a second upper resonator **770.** The lower resonator **740** comprises a bottom electrode **742,** an upper electrode **746** and a piezoelectric layer **744** disposed between the electrodes **742** and **746.** The first delay **752** and the second delay **754,** which are separately disposed on top of the lower resonator **740,** are composed of a plurality of layers of different dielectric materials. The structure of the first delay **752** and the second delay **754** can be SiO₂/W/SiO₂, for example. The first upper resonator **760,** which is disposed on top of the first delay **752,** comprises a bottom electrode **762,** an upper electrode **766** and a piezoelectric layer **764** therebetween. The second upper resonator **770,** which is disposed on top of the first delay **754,** comprises a bottom electrode **772,** an upper electrode **776** and a piezoelectric layer **774** therebetween. The resonator device **700** may comprise an acoustically reflecting membrane with a cavity (see Figure 1a), a sacrificial layer (see Figure 1c), or an acoustic mirror **734** under the lower resonator **740.** One of the upper resonators is used as a signal input port and the other is used as a signal output port. As shown in Figure 10, the electrodes **766, 762** are connected to terminals **72** and **74;** and the electrodes **776, 772** are connected to terminals **76** and **78.** If first upper resonator **760** is used to excite an acoustic wave by an electric signal through terminals **72, 74,** the acoustic wave propagates to the lower resonator **740** through the first delay **752.** At the lower resonator **740,** the acoustic wave in the piezoelectric layer **744** is converted into electrical signal. The electrical signal in the electrodes **742, 746** is again converted into an acoustic wave, which propagates to the second upper resonator **770** through the second delay **754.** At the resonator **770,** the acoustic wave is converted back to an electric signal at the terminals **76, 78.** The acoustic excitation within the CRF **710** and CRF **720,** and electrical coupling between them is shown in Figure 11. The first upper resonator **760** and the second upper resonator **770** typically exhibit slightly different resonant frequencies in order to shape the passband response.

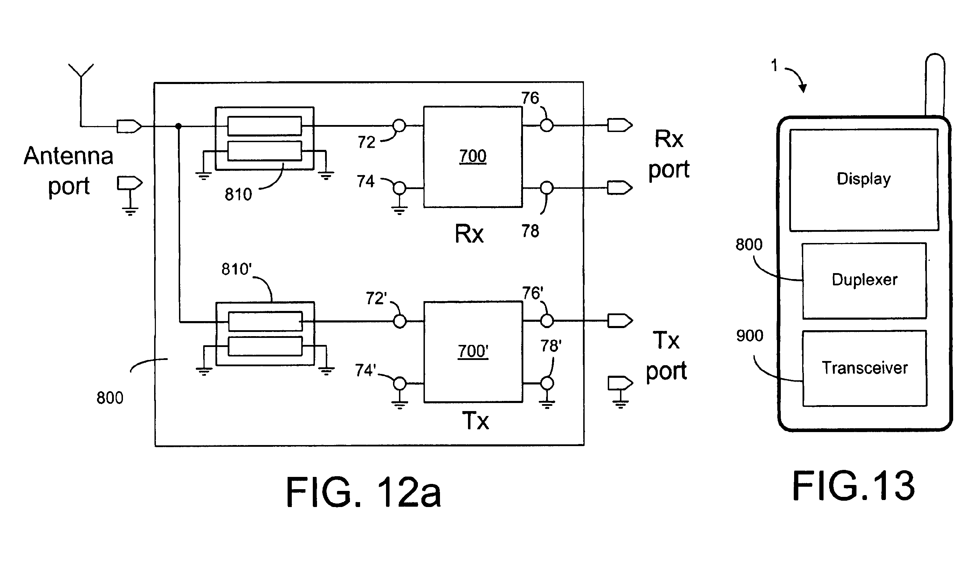

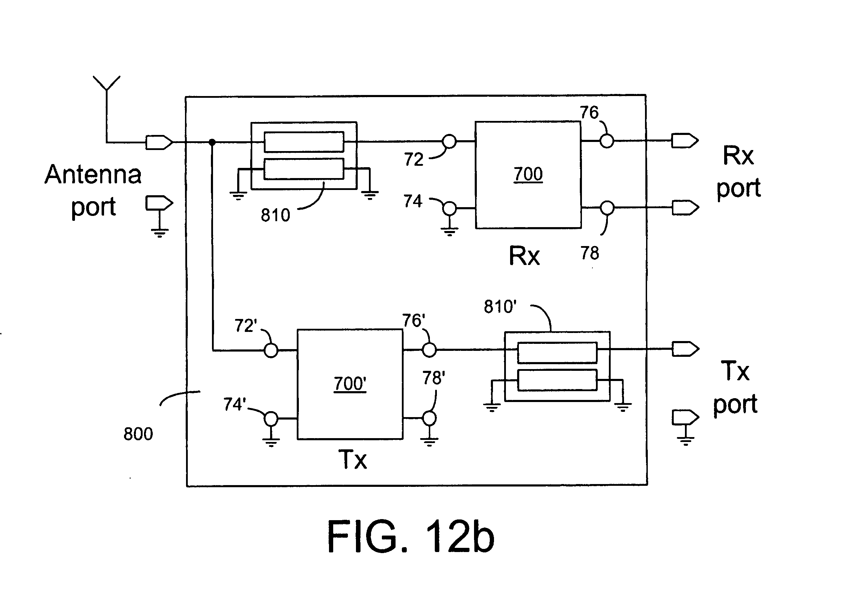

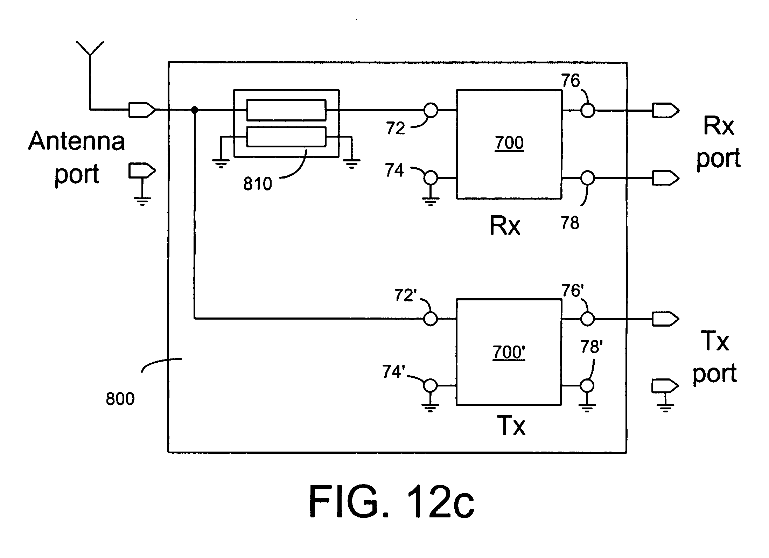

The resonator device **700,** according to the present invention, can be used in a duplexer as shown in Figure 12a. As shown, the duplexer **800** comprises a Tx part and an Rx part separately connected to a Tx port and an Rx port, respectively. In the Rx part, the resonator device **700** is used as a single-to-balanced filter in that the terminal **74** is connected to ground. The resonator **700** is connected to a common antenna port through a phase shifter **810.** In the Tx part, the resonator device **700'** is used as a single-to-single filter in that both the terminal **74'** and terminal **78'** are connected to ground. The resonator **700'** is connected to the common antenna port through a phase shifter **810'.** The phase shifters **810** and **810'** can be made of transmission lines, lump elements such as inductors and coils, or the like. The phase shifters **810, 810'** can be integrated with the corresponding resonator devices **700, 700'** if plausible. Furthermore, the phase shifter **810'** can be disposed between the resonator device **700'** and the Tx port, as shown in Figure 12b. It is possible to omit the phase shifter **810'** in the Tx part, as shown in Figure 12c. Depending on the guard bandwidth between the Tx part and Rx part, the duplexer **800** can be used in a W-CDMA or CDMA transceiver.

The duplexer **800,** according to the present invention, can be used in a communications device, such as a mobile phone, as shown in Figure 13. As shown, the duplexer **800** is operatively connected to the Rx and Tx ports of the transceiver 900 in the communications device **1.**

It should be noted that the resonator device **700** as shown in Figure 10 has two CRF stages, but can have more than two CRF stages. Similarly, the resonator device **700** in the Rx part and the resonator device **700'** can be coupled to other CRF stages or other similar resonator devices, depending on the frequency selectivity requirements of the transceiver. If necessary, one or more phase shifters, similar to the phase shifter **242** in Figures 6 and 7, can be used for matching. The phase shifters can be based on lump elements (such as inductors and coils), or microstrip lines on the duplexer substrate, which may be organic laminate or LTCC (low-temperature cofire ceramic), for example.

The advantages of the duplexer, according to the present invention, include that the out-of-band attenuation far from the passband is greatly improved over the convention duplexers, and that the losses seen at both the Rx and Tx paths are reduced because no magnetic balun is required for the fully balanced Rx part. It should also be noted that impedance level transformation is possible in the duplexer, according to the present invention.

Although the invention has been described with respect to a preferred embodiment thereof, it will be understood by those skilled in the art that the foregoing and various other changes, omissions and deviations in the form and detail thereof may be made without departing from the scope of this invention.

## Claims

1. A duplexer (800) for use in a communication device (1), the communication device having
an antenna for conveying communication signals;
a transmit path operatively connected to the antenna for transmitting the signals; and
a receive path operatively connected to the antenna for receiving the signals, said duplexer comprising:
a first coupled resonator device (700') disposed in the transmit path for filtering the signals in the transmit path;
a second coupled resonator device (700) disposed in the receive path for filtering the signals in the receive path; and
a phase shifter (810) disposed in the receive path and operatively connected to the second coupled resonator device, wherein each of said first and second coupled resonator devices (700, 700') comprises:
an input end for receiving the signals in the corresponding path, and an output end for providing filtered signals in the corresponding path;
a first resonator (760) operatively connected to the input end to provide acoustic wave signals indicative of the received signals;
a first delay section (752), responsive to the acoustic wave signals, for providing delayed acoustic wave signals;
an intermediate resonator (740) having a first end and a second end, responsive to the delayed acoustic wave signals at the first end, for producing at the first and second ends electric signals indicative of the delayed acoustic wave signals for generating further acoustic wave signals at the second end;
a second delay section (754), responsive to the further acoustic wave signals, for providing further delayed acoustic wave signals; and
a second resonator (770) operatively connected to the output end, for providing the filtered signals to the output end responsive to the further delayed acoustic wave signals,
**characterised in that** the first delay section (752) and the second delay section (754) are separately disposed on the intermediate resonator (740).

2. The duplexer of claim 1, wherein the phase shifter is disposed between the second coupled resonator device and the antenna.

3. The duplexer of claim 2, further comprising a further phase shifter (810') disposed in the transmit path and operatively connected to the first coupled resonator device (700').

4. The duplexer of claim 3, wherein the further phase shifter (810') is disposed between the first coupled resonator device (700') and the antenna.

5. The duplexer of claim 3, wherein the first coupled resonator device (700') is disposed between the further phase shifter (810') and the antenna.

6. The duplexer of claim 1, wherein
the input end of the first coupled resonator device (700') comprises two input terminals (76', 78'), and
the output end of the first coupled resonator device comprises two output terminals (72', 74'), and wherein
one of the two input terminals and one of the two output terminals are operatively connected to ground.

7. The duplexer of claim 1, wherein
the input end of the second coupled resonator device (700) comprises two input terminals (72, 74), and wherein
one of the two input terminals is operatively connected to ground to achieve a single-to-balanced transformation.

8. The duplexer of claim 7, wherein
the input end of the first coupled resonator device (700') comprises two input terminals (76', 78'), and
the output end of the first coupled resonator device comprises two output terminals (72', 74'), and wherein
one of the two input terminals and one of the two output terminals are operatively connected to ground.

9. The duplexer of claim 1, wherein the first and second resonators (760, 770) are bulk acoustic wave devices.

10. The duplexer of claim 3, wherein each of the phase shifter (810) and the further phase shifter (810') comprises a transmission line.

11. The duplexer of claim 3, wherein each of the phase shifter (810) and the further phase shifter (810') comprises one or more lump elements.

12. The duplexer of claim 3, wherein the further phase shifter (810') comprises one or more lump elements integrated with the first coupled resonator device.

13. A communication device (1) comprising:
an antenna port for conveying communication signals;
a transceiver having a transmit port and a receive port; and
a duplexer (800) according to claim 1.

14. The communication device of claim 13, wherein the duplexer (800) further comprises:
a further phase shifter (810') disposed in the transmit path and operatively connected to the first coupled resonator device (700').

15. The communication device of claim 13, comprising a mobile terminal.

16. The communication device of claim 13, wherein each of the first and second delay sections (752, 754) in the first and second coupled devices (700, 700') comprises a structure composed of silicon dioxide and tungsten layers.

17. The communication device of claim 13, wherein the first coupled resonator device (700') has a single-to-single configuration and the second coupled resonator device (700) has a single-to-balanced transformation.

18. A coupled resonator device, comprising:
an input end for receiving the signals in the corresponding path, and an output end for providing filtered signals in the corresponding path;
a first resonator (760), operatively connected to the input end to provide acoustic wave signals indicative of the received signals;
a first delay section (752), responsive to the acoustic wave signals, for providing delayed acoustic wave signals;
an intermediate resonator (740) having a first end and a second end, responsive to the delayed acoustic wave signals at the first end, for producing electric signals at the first and second ends indicative of the delayed acoustic wave signals for generating further acoustic wave signals at the second end;
a second delay section (754), responsive to the further acoustic wave signals, for providing further delayed acoustic wave signals; and
a second resonator (770), operatively connected to the output end, for providing the filtered signals to the output end responsive to the further delayed acoustic wave signals,
**characterised in that** the first delay section (752) and the second delay section (754) are separately disposed on the intermediate resonator (740).

19. The resonator device of claim 18, further comprising a substrate (730), wherein the intermediate resonator (740) comprises:
a first electrode (742) disposed on the substrate;
a piezoelectric layer (744) disposed on the first electrode; and
a second electrode (746) disposed on the piezoelectric layer, the second electrode having a first end and a second end, and wherein
the first delay section (752) is disposed on the first end of the second electrode;
the second delay section (754) is disposed on the second end of the second electrode;
the first resonator (760) is disposed on the first delay section; and
the second resonator (770) is disposed on the second delay section.

20. The resonator device of claim 18, wherein each of the first and second resonators (760, 770) comprises a pair of electrodes and a further piezoelectric layer disposed between said pair of electrodes.

21. The resonator device of claim 19, further comprising
an acoustic mirror (734) disposed adjacent to the intermediate resonator (740), between the first electrode (742) and the substrate (730).

22. The resonator device of claim 18, wherein each of the first and second delay sections (752, 754) comprises a plurality of dielectric materials.

23. The resonator device of claim 18, wherein each of the first and second delay sections (752, 754) comprises a structure composed of silicon dioxide and tungsten layers.

24. The resonator device of claim 18, wherein the input end comprises two input terminals (72, 74), and wherein one of the two input terminals is operatively connected to a non-acoustic phase shifting component.

25. The resonator device of claim 24, wherein the other of the two input terminals is operatively connected to ground.

26. The resonator device of claim 18, wherein the first resonator (760) has a first resonant frequency and the second resonator (770) has a second resonant frequency slightly different from the first resonant frequency.

## Patentansprüche

1. Duplexer (800) zur Verwendung in einer Kommunikationsvorrichtung (1), wobei die Kommunikationsvorrichtung Folgendes aufweist:
eine Antenne zum Übermitteln von Kommunikationssignalen;
einen wirksam mit der Antenne verbundenen Sendepfad zum Senden der Signale; und
einen wirksam mit der Antenne verbundenen Empfangspfad zum Empfangen der Signale, wobei der Duplexer Folgendes umfasst:
eine im Sendepfad angeordnete erste Koppelresonatorvorrichtung (700') zum Filtern der Signale im Sendepfad;
eine im Empfangspfad angeordnete zweite Koppelresonatorvorrichtung (700) zum Filtern der Signale im Empfangspfad; und
einen im Empfangspfad angeordneten und wirksam mit der zweiten Koppelresonatorvorrichtung verbundenen Phasenschieber (810), wobei jede der ersten und zweiten Koppelresonatorvorrichtung (700, 700') Folgendes umfasst:
ein Eingangsende zum Empfangen der Signale im entsprechenden Pfad und ein Ausgangsende zum Bereitstellen von gefilterten Signalen im entsprechenden Pfad;
einen wirksam mit dem Eingangsende verbundenen ersten Resonator (760) zum Bereitstellen von akustischen Wellensignalen, die die empfangenen Signale angeben;
einen auf die akustischen Wellensignale ansprechenden ersten Verzögerungsteil (752) zum Bereitstellen von verzögerten akustischen Wellensignalen,
einen Zwischenresonator (740) mit einem ersten Ende und einem zweiten Ende, der am ersten Ende auf die verzögerten akustischen Wellensignale anspricht, zum Produzieren von elektrischen Signalen am ersten und zweiten Ende, die die verzögerten akustischen Wellensignale angeben, um am zweiten Ende weitere akustische Wellensignale zu erzeugen;
einen auf die weiteren akustischen Wellensignale ansprechenden zweiten Verzögerungsteil (754) zum Bereitstellen weiterer verzögerter akustischer Wellensignale; und
einen wirksam mit dem Ausgangsende verbundenen zweiten Resonanter (770) zum Leiten der gefilterten Signale zu dem Ausgangsende als Reaktion auf die weiteren verzögerten akustischen Wellensignale,
**dadurch gekennzeichnet, dass** der erste Verzögerungsteil (752) und der zweite Verzögerungsteil (754) separat auf dem Zwischenresonator (740) angeordnet sind.

2. Duplexer nach Anspruch 1, wobei der Phasenschieber zwischen der zweiten Koppelresonatorvorrichtung und der Antenne angeordnet ist.

3. Duplexer nach Anspruch 2, der ferner einen weiteren Phasenschieber (810') umfasst, der im Sendepfad angeordnet und wirksam mit der ersten Koppelresonatorvorrichtung (700') verbunden ist.

4. Duplexer nach Anspruch 3, wobei der weitere Phasenschieber (810') zwischen der ersten Koppelresonatorvorrichtung (700') und der Antenne angeordnet ist.

5. Duplexer nach Anspruch 3, wobei die erste Koppelresonatorvorrichtung (700') zwischen dem weiteren Phasenschieber (810') und der Antenne angeordnet ist.

6. Duplexer nach Anspruch 1, wobei
das Eingangsende der ersten Koppelresonatorvorrichtung (700') zwei Eingangsanschlüsse (76', 78') umfasst und
das Ausgangsende der ersten Koppelresonatorvorrichtung zwei Ausgangsanschlüsse (72', 74') umfasst und wobei
einer der zwei Eingangsanschlüsse und einer der zwei Ausgangsanschlüsse wirksam mit Masse verbunden sind.

7. Duplexer nach Anspruch 1, wobei
das Eingangsende der zweiten Koppelresonatorvorrichtung (700) zwei Eingangsanschlüsse (72, 74) umfasst und wobei
einer der zwei Eingangsanschlüsse wirksam mit Masse verbunden ist, um eine Transformation von asymmetrisch in symmetrisch zu erzielen.

8. Duplexer nach Anspruch 7, wobei
das Eingangsende der ersten Koppelresonatorvorrichtung (700') zwei Eingangsanschlüsse (76', 78') umfasst und
das Ausgangsende der ersten Koppelresonatorvorrichtung zwei Ausgangsanschlüsse (72', 74') umfasst und wobei einer der zwei Eingangsanschlüsse und einer der zwei Ausgangsanschlüsse wirksam mit Masse verbunden sind.

9. Duplexer nach Anspruch 1, wobei der erste und zweite Resonator (760, 770) akustische Volumenwellenvorrichtungen sind.

10. Duplexer nach Anspruch 3, wobei der Phasenschieber (810) und der weitere Phasenschieber (810') jeweils eine Übertragungsleitung umfassen.

11. Duplexer nach Anspruch 3, wobei der Phasenschieber (810) und der weitere Phasenschieber (810') jeweils ein oder mehrere konzentrierte Elemente umfassen.

12. Duplexer nach Anspruch 3, wobei der weitere Phasenschieber (810') ein oder mehrere mit der ersten Koppelresonatorvorrichtung integrierte konzentrierte Elemente umfasst.

13. Kommunikationsvorrichtung (1), umfassend:
einen Antennenport zum Übermitteln von Kommunikationssignalen;
einen Sender/Empfänger mit einem Sendeport und einem Empfangsport; und
einen Duplexer (800) nach Anspruch 1.

14. Kommunikationsvorrichtung nach Anspruch 13, wobei der Duplexer (800) ferner Folgendes umfasst:
einen weiteren Phasenschieber (810'), der im Sendepfad angeordnet und wirksam mit der ersten Koppelresonatorvorrichtung (700') verbunden ist.

15. Kommunikationsvorrichtung nach Anspruch 13, die ein mobiles Endgerät umfasst.

16. Kommunikationsvorrichtung nach Anspruch 13, wobei der erste und zweite Verzögerungsteil (752, 754) in der ersten und zweiten Koppelvorrichtung (700, 700') jeweils eine aus Siliziumdioxid- und Wolframschichten zusammengesetzte Struktur umfassen.

17. Kommunikationsvorrichtung nach Anspruch 13, wobei die erste Koppelresonatorvorrichtung (700') eine Konfiguration von asymmetrisch zu asymmetrisch aufweist und die zweite Koppelresonatorvorrichtung (700) eine Transformation von asymmetrisch in symmetrisch aufweist.

18. Koppelresonatorvorrichtung, umfassend:
ein Eingangsende zum Empfangen der Signale im entsprechenden Pfad und ein Ausgangsende zum Bereitstellen von gefilterten Signalen im entsprechenden Pfad;
einen wirksam mit dem Eingangsende verbundenen ersten Resonator (760) zum Bereitstellen von akustischen Wellensignalen, die die empfangenen Signale angeben;
einen auf die akustischen Wellensignale ansprechenden ersten Verzögerungsteil (752) zum Bereitstellen von verzögerten akustischen Wellensignalen,
einen Zwischenresonator (740) mit einem ersten Ende und einem zweiten Ende, der am ersten Ende auf die verzögerten akustischen Wellensignale anspricht, zum Produzieren von elektrischen Signalen am ersten und zweiten Ende, die die verzögerten akustischen Wellensignale angeben, um am zweiten Ende weitere akustische Wellensignale zu erzeugen;
einen auf die weiteren akustischen Wellensignale ansprechenden zweiten Verzögerungsteil (754) zum Bereitstellen weiterer verzögerter akustischer Wellensignale; und
einen wirksam mit dem Ausgangsende verbundenen zweiten Resonator (770) zum Leiten der gefilterten Signale zu dem Ausgangsende als Reaktion auf die weiteren verzögerten akustischen Wellensignale,
**dadurch gekennzeichnet, dass** der erste Verzögerungsteil (752) und der zweite Verzögerungsteil (754) separat auf dem Zwischenresonator (740) angeordnet sind.

19. Resonatorvorrichtung nach Anspruch 18, die ferner ein Substrat (730) umfasst, wobei der Zwischenresonator (740) Folgendes umfasst:
eine auf dem Substrat angeordnete erste Elektrode (742);
eine auf der ersten Elektrode angeordnete piezoelektrische Schicht (744); und
eine auf der piezoelektrischen Schicht angeordnete zweite Elektrode (746), wobei die zweite Elektrode ein erstes Ende und ein zweites Ende aufweist und wobei
der erste Verzögerungsteil (752) an dem ersten Ende der zweiten Elektrode angeordnet ist;
der zweite Verzögerungsteil (754) an dem zweiten Ende der zweiten Elektrode angeordnet ist;
der erste Resonator (760) an dem ersten Verzögerungsteil angeordnet ist; und
der zweite Resonator (770) an dem zweiten Verzögerungsteil angeordnet ist.

20. Resonatorvorrichtung nach Anspruch 18, wobei der erste und zweite Resonator (760, 770) jeweils ein Elektrodenpaar und eine zwischen dem Elektrodenpaar angeordnete weitere piezoelektrische Schicht umfassen.

21. Resonatorvorrichtung nach Anspruch 19, ferner umfassend:
einen an den Zwischenresonator (740) angrenzend angeordneten akustischen Spiegel (734) zwischen der ersten Elektrode (742) und dem Substrat (730).

22. Resonatorvorrichtung nach Anspruch 18, wobei der erste und zweite Verzögerungsteil (752, 754) jeweils eine Vielzahl dielektrischer Materialien umfassen.

23. Resonatorvorrichtung nach Anspruch 18, wobei der erste und zweite Verzögerungsteil (752, 754) jeweils eine aus Siliziumdioxid- und Wolframschichten zusammengesetzte Struktur umfassen.

24. Resonatorvorrichtung nach Anspruch 18, wobei das Eingangsende zwei Eingangsanschlüsse (72, 74) umfasst und wobei einer der zwei Eingangsanschlüsse wirksam mit einer nichtakustischen Phasenverschiebungskomponente verbunden ist.

25. Resonatorvorrichtung nach Anspruch 24, wobei der andere der zwei Eingangsanschlüsse wirksam mit Masse verbunden ist.

26. Resonatorvorrichtung nach Anspruch 18, wobei der erste Resonator (760) eine erste Resonanzfrequenz aufweist und der zweite Resonator (770) eine von der ersten Resonanzfrequenz etwas verschiedene zweite Resonanzfrequenz aufweist.

## Revendications

1. Duplexeur (800) destiné à être utilisé dans un dispositif de communication (1), le dispositif de communication ayant
une antenne pour acheminer des signaux de communication ;
un chemin d'émission connecté opérationnellement à l'antenne pour émettre les signaux ; et
un chemin de réception connecté opérationnellement à l'antenne pour recevoir les signaux, ledit duplexeur comprenant :
un premier dispositif résonateur couplé (700') disposé dans le chemin d'émission pour filtrer les signaux dans le chemin d'émission ;
un second dispositif résonateur couplé (700) disposé dans le chemin de réception pour filtrer les signaux dans le chemin de réception ; et
un déphaseur (810) disposé dans le chemin de réception et connecté opérationnellement au second dispositif résonateur couplé, dans lequel chacun desdits premier et second dispositifs résonateurs couplés (700, 700') comprend :
une extrémité d'entrée pour recevoir les signaux dans le chemin correspondant, et une extrémité de sortie pour fournir des signaux filtrés dans le chemin correspondant ;
un premier résonateur (760) connecté opérationnellement à l'extrémité d'entrée pour fournir des signaux d'ondes acoustiques indicatifs des signaux reçus ;
une première section à retard (752), sensible aux signaux d'ondes acoustiques, pour fournir des signaux d'ondes acoustiques retardés ;
un résonateur intermédiaire (740) ayant une première extrémité et une seconde extrémité, sensible aux signaux d'ondes acoustiques retardés au niveau de la première extrémité, pour produire au niveau des première et seconde extrémités des signaux électriques indicatifs des signaux d'ondes acoustiques retardés pour générer d'autres signaux d'ondes acoustiques au niveau de la seconde extrémité ;
une seconde section de retard (754), sensible aux autres signaux d'ondes acoustiques, pour fournir d'autres signaux d'ondes acoustiques retardés ; et un second résonateur (770) connecté opérationnellement à l'extrémité de sortie, pour fournir les signaux filtrés à l'extrémité de sortie en réponse aux autres signaux d'ondes acoustiques retardés,
**caractérisé en ce que** la première section à retard (752) et la seconde section à retard (754) sont disposées séparément sur le résonateur intermédiaire (740).

2. Duplexeur selon la revendication 1, dans lequel le déphaseur est disposé entre le second dispositif résonateur couplé et l'antenne.

3. Duplexeur selon la revendication 2, comprenant en outre un autre déphaseur (810') disposé dans le chemin d'émission et connecté opérationnellement au premier dispositif résonateur couplé (700').

4. Duplexeur selon la revendication 3, dans lequel l'autre déphaseur (810') est disposé entre le premier dispositif résonateur couplé (700') et l'antenne.

5. Duplexeur selon la revendication 3, dans lequel le premier dispositif résonateur couplé (700') est disposé entre l'autre déphaseur (810') et l'antenne.

6. Duplexeur selon la revendication 1, dans lequel
l'extrémité d'entrée du premier dispositif résonateur couplé (700') comprend deux bornes d'entrée (76', 78'), et
l'extrémité de sortie du premier dispositif résonateur couplé comprend deux bornes de sortie (72', 74'), et dans lequel
l'une des deux bornes d'entrée et l'une des deux bornes de sortie sont connectées opérationnellement à la masse.

7. Duplexeur selon la revendication 1, dans lequel
l'extrémité d'entrée du second dispositif résonateur couplé (700) comprend deux bornes d'entrée (72, 74), et dans lequel
l'une des deux bornes d'entrée est connectée opérationnellement à la masse pour réaliser une transformation asymétrique-symétrique.

8. Duplexeur selon la revendication 7, dans lequel
l'extrémité d'entrée du premier dispositif résonateur couplé (700') comprend deux bornes d'entrée (76', 78'), et
l'extrémité de sortie du premier dispositif résonateur couplé comprend deux bornes de sortie (72', 74') et dans lequel
l'une des deux bornes d'entrée et l'une des deux bornes de sortie sont connectées opérationnellement à la masse.

9. Duplexeur selon la revendication 1, dans lequel les premier et second résonateurs (760, 770) sont des dispositifs à ondes acoustiques de volume.

10. Duplexeur selon la revendication 3, dans lequel chacun du déphaseur (810) et de l'autre déphaseur (810') comprend une ligne de transmission.

11. Duplexeur selon la revendication 3, dans lequel chacun du déphaseur (810) et de l'autre déphaseur (810') comprend une ou plusieurs constantes localisées.

12. Duplexeur selon la revendication 3, dans lequel l'autre déphaseur (810') comprend une ou plusieurs constantes localisées intégrées au premier dispositif résonateur couplé.

13. Dispositif de communication (1) comprenant :
un port d'antenne pour acheminer des signaux de communication ;
un émetteur-récepteur ayant un port d'émission et un port de réception ; et
un duplexeur (800) selon la revendication 1.

14. Dispositif de communication selon la revendication 13, dans lequel le duplexeur (800) comprend en outre :
un autre déphaseur (810') disposé dans le chemin d'émission et connecté opérationnellement au premier dispositif résonateur couplé (700').

15. Dispositif de communication selon la revendication 13, comprenant un terminal mobile.

16. Dispositif de communication selon la revendication 13, dans lequel chacune des première et seconde sections à retard (752, 754) dans les premier et second dispositifs couplés (700, 700') comprend une structure composée de couches de dioxyde de silicium et de tungstène.

17. Dispositif de communication selon la revendication 13, dans lequel le premier dispositif résonateur couplé (700') a une configuration asymétrique-asymétrique et le second dispositif résonateur couplé (700) a une transformation asymétrique-symétrique.

18. Dispositif résonateur couplé, comprenant :
une extrémité d'entrée pour recevoir les signaux dans le chemin correspondant, et une extrémité de sortie pour fournir les signaux filtrés dans le chemin correspondant ;
un premier résonateur (760), connecté opérationnellement à l'extrémité d'entrée pour fournir des signaux d'ondes acoustiques indicatifs des signaux reçus ;
une première section à retard (752), sensible aux signaux d'ondes acoustiques, pour fournir des signaux d'ondes acoustiques retardés ;
un résonateur intermédiaire (740) ayant une première extrémité et une seconde extrémité, sensible aux signaux d'ondes acoustiques retardés au niveau de la première extrémité, pour produire aux première et seconde extrémités des signaux électriques indicatifs des signaux d'ondes acoustiques retardés pour générer d'autres signaux d'ondes acoustiques au niveau de la seconde extrémité ;
une seconde section à retard (754), sensible aux autres signaux d'ondes acoustiques, pour fournir d'autres signaux d'ondes acoustiques retardés ; et
un second résonateur (770) connecté opérationnellement à l'extrémité de sortie, pour fournir les signaux filtrés à l'extrémité de sortie en réponse aux autres signaux d'ondes acoustiques retardés,
**caractérisé en ce que** la première section à retard (752) et la seconde section à retard (754) sont disposées séparément sur le résonateur intermédiaire (740).

19. Dispositif résonateur selon la revendication 18, comprenant en outre un substrat (730), dans lequel le résonateur intermédiaire (740) comprend :
une première électrode (742) disposée sur le substrat ;
une couche piézoélectrique (744) disposée sur la première électrode ; et
une seconde électrode (746) disposée sur la couche piézoélectrique, la seconde électrode ayant une première extrémité et une seconde extrémité, et dans lequel
la première section à retard (752) est disposée sur la première extrémité de la seconde électrode ;
la seconde section à retard (754) est disposée sur la seconde extrémité de la seconde électrode ;
le premier résonateur (760) est disposé sur la première section à retard ; et
le second résonateur (770) est disposé sur la seconde section à retard.

20. Dispositif résonateur selon la revendication 18, dans lequel chacun des premier et second résonateurs (760, 770) comprend une paire d'électrodes et une autre couche piézoélectrique disposée entre ladite paire d'électrodes.

21. Dispositif résonateur selon la revendication 19, comprenant en outre
un miroir acoustique (734) disposé à proximité du résonateur intermédiaire (740) entre la première électrode (742) et le substrat (730).

22. Dispositif résonateur selon la revendication 18, dans lequel chacune des première et seconde sections à retard (752, 754) comprend une pluralité de matériaux diélectriques.

23. Dispositif résonateur selon la revendication 18, dans lequel chacune des première et seconde sections à retard (752, 754) comprend une structure composée de couches de dioxyde de silicium et de tungstène.

24. Dispositif résonateur selon la revendication 18, dans lequel l'extrémité d'entrée comprend deux bornes d'entrée (72, 74), et dans lequel l'une des deux bornes d'entrée est connectée opérationnellement à un composant de déphasage non acoustique.

25. Dispositif résonateur selon la revendication 24, dans lequel l'autre des deux bornes d'entrée est connectée opérationnellement à la masse.

26. Dispositif résonateur selon la revendication 18, dans lequel le premier résonateur (760) a une première fréquence de résonance et le second résonateur (770) a une seconde fréquence de résonance légèrement différente de la première fréquence de résonance.
